(19) **European Patent Office**

Europäisches Patentamt

European Patent Office

Office européen des brevets

(11) **EP 1 561 572 A1**

(12) **EUROPEAN PATENT APPLICATION**
published in accordance with Art. 158(3) EPC

(43) Date of publication:
**10.08.2005 Bulletin 2005/32**

(51) Int Cl.7: **B32B 15/04**, A61J 1/00,
B65D 30/02, B65D 65/40

(21) Application number: **02808123.0**

(22) Date of filing: **14.11.2002**

(86) International application number:
**PCT/JP2002/011878**

(87) International publication number:
**WO 2004/043690 (27.05.2004 Gazette 2004/22)**

(84) Designated Contracting States:
**AT BE BG CH CY CZ DE DK EE ES FI FR GB GR
IE IT LI LU MC NL PT SE SK TR**
Designated Extension States:
**AL LT LV MK RO SI**

(71) Applicants:
• **KABUSHIKI KAISHA HOSOKAWA YOKO
Tokyo 102-0084 (JP)**
• **Nishiyama, Katsuhiro
Kitasoma-gun, Ibaraki 300-1622 (JP)**
• **Abe, Masahiko
Noda-city, Chiba 278-0017 (JP)**

(72) Inventors:
• **NISHIYAMA, Katsuhiro
Tone-machi, Kitasoma-gun, Ibaraki 300-16 (JP)**

• **ABE, Masahiko
Noda-shi, Chiba 278-0017 (JP)**
• **KUGE, Raizo Kabushiki Kaisha Hosokawa Yoko
Chiyoda-ku, Tokyo 102-0084 (JP)**
• **NIWA, Susumu
Kabushiki Kaisha Hosokawa Yoko
Chiyoda-ku, Tokyo 102-0084 (JP)**

(74) Representative: **Finnie, Peter John
Gill Jennings & Every,
Broadgate House,
7 Eldon Street
London EC2M 7LH (GB)**

(54) **MULTILAYER SHEET AND PACKAGING MATERIAL FOR FOOD, MEDICINE, AND TOOL FOR FOOD, MEDICEN, AND TOOL**

(57)     A multilayer sheet harmless to human beings, having a certain gas-barrier property, and comprising an easily-produced metal film layer and a packaging material made of the multilayer sheet. The multilayer sheet is composed of at least a resin film layer and a metal film layer of magnesium or a magnesium alloy integrally formed on the resin film layer by evaporation, electron beam, or sputtering. Magnesium is harmless to human beings, and therefore such a multilayer sheet can be preferably used as a material of a food or medicine bag.

EP 1 561 572 A1

## Description

## Technical Field

This invention relates to a multilayer sheet and also to a package body made from the multilayer sheet for packaging food, medicine or tool.

## Background Art

Multilayer sheets comprising a base layer that is a resin film layer and a metal film layer integrally formed on the resin film layer by lamination or the like are known. Aluminum film or film of an aluminum alloy is typically used for the metal film layer. Generally, aluminum film is rolled to a very thin foil by means of a rolling mill and bonded to the surface of resin film. Such multilayer sheet is widely used package body for packaging food, medicine and tools because the gas impermeability of the aluminum foil prevents degradation of the sealed contents.

However, medical data have been revealed in recent years to prove harmful effects of aluminum on the human body. Now, there is a demand for a metal film layer that can replace the aluminum film layer of multilayer sheet under consideration for the above-identified reason and also from the viewpoint of resource saving. However, no multilayer sheet comprising a metal film layer showing a level of gas impermeability equal to or higher than that of aluminum film have been provided to date.

In view of the above identified circumstances, it is therefore an object of the present invention to provide a multilayer sheet comprising a metal film layer that shows a certain level of gas impermeability and can be manufactured with ease and a package body made from the multilayer sheet.

## Disclosure of the Invention

According to the invention, the above object is achieved by providing a multilayer sheet including a base layer and at least a metal film layer integrally formed on the base layer. The metal film layer is made of magnesium or a magnesium alloy. With this construction, the multilayer sheet is harmless to the human body and impermeable to gas to a certain extent and at the same time can replace aluminum to save the precious resource of aluminum, since the metal film layer is made of magnesium or a magnesium alloy.

It is preferable that the metal film layer is formed on the base layer by means of a sublimation method, an evaporation method, an electron beam method or a sputtering method. With this construction, the metal film layer can be formed on the base layer by means of a sublimation method, an evaporation method, an electron beam method or a sputtering method. Therefore, existing evaporation facilities or the like can be used without modification so that it is possible to form the metal film layer with ease. When an evaporation process is used, it is possible to select the degree of vacuum of the container from a broad range between several mmHg through $10^{-8}$ mmHg. Accordingly, degree of freedom for the film forming conditions can be increased. Additionally, when a magnesium alloy is used, it is possible to form a highly pure magnesium film layer (99.99 to 99.999%) by selecting an appropriate vacuum condition.

Additionally, the present invention provides a package body for packaging food, medicine or tool made from a multilayer sheet. The multilayer sheet includes a base layer and at least a metal film layer integrally formed on the base layer. The metal film layer is made of magnesium or a magnesium alloy. With this construction, the package body for packaging food, medicine or tool is also harmless to the human body and impermeable to gas to a certain extent and at the same time can replace aluminum to save the precious resource of aluminum, since the metal film layer is made of magnesium or a magnesium alloy.

It is preferable that the metal film layer is formed on the base layer by means of a sublimation method, an evaporation method, an electron beam method or a sputtering method. With this construction, the metal film layer can be formed on the base layer by means of a sublimation method, an evaporation method, an electron beam method or a sputtering method. Therefore, existing evaporation facilities or the like can be used without modification so that it is possible to form the metal film layer with ease. When an evaporation process is used, it is possible to select the degree of vacuum of the container from a broad range between several mmHg through $10^{-8}$ mmHg. Accordingly, degree of freedom for the film forming conditions can be increased. Additionally, when a magnesium alloy is used, it is possible to form a highly pure magnesium film layer (99.99 to 99.999%) by selecting an appropriate vacuum condition.

## Best Mode for Carrying Out the Invention

Now, an embodiment of multilayer sheet according to the invention will be described below. A multilayer sheet according to the invention comprises a base layer, which is a resin film layer, and a magnesium film layer formed on the resin film layer. The resin film layer has a thickness of 0.1 μm through 2 mm and made of a known plastic material.

Examples of plastic material that can be used for the resin film layer include polyethylene, polypropylene, polystyrene, polyvinyl chloride, polyvinylidene chloride, polyvinyl alcohol, fluoroethylene resin, polycarbonate, polyester, polyamide, rubber hydrochloride, ionomer, polyimide, polyurethane, heat-resistant engineering film, polyethylene terephthalate, 1,4-cyclohexylene dimethyl terephthalate, polyvinyl fluoride, polytetraphloroethylene, cellophane, gelatin, cellulose triacetate, polymethyl methacrylate, cellulose diacetate and hard vinyl chloride. Examples of heat-resistant engineering film that can be used for the purpose of the present embodiment include polyphenylene sulfide (PPS), polyarylate (PAr), polysulfone (PSF), polyetheretherketone (PEEK) and polyetherimide (PEI).

The magnesium film layer has a thickness of 5Å through 1000 Å and made of magnesium or magnesium alloy made of magnesium and another metal and element. Examples of another metal and element include Ag, Al, Au, Ba, Bi, Ca, Ce, Co, Cr, Cu, Fe, Gd, Ge, H, Hf, Hg, In, Ir, K, La, Li, Mn, Mo, N, Na, Ni, O, Os, P, Pb, Pd, Pr, Pt, Pu, Rh, S, Sb, Se, Si, Sn, Sr, Te, Th, Ti, T1, U, W, Y, Zn, Zr, RE. Examples of binary alloy of magnesium alloy include Mg-Ag, Mg-Al, Mg-Au, Mg-Ba, Mg-Bi, Mg-Ca, Mg-Ce, Mg-Co, Mg-Cr, Mg-Cu, Mg-Fe, Mg-Gd, Mg-Ge, Mg-H, Mg-Hf, Mg-Hg, Mg-In, Mg-Ir, Mg-K, Mg-La, Mg-Li, Mg-Mn, Mg-Mo, Mg-N, Mg-Na, Mg-Ni, Mg-O, Mg-Os, Mg-P, Mg-Pb, Mg-Pd, Mg-Pr, Mg-Pt, Mg-Pu, Mg-Rh, Mg-S, Mg-Sb, Mg-Se, Mg-Si, Mg-Sn, Mg-Sr, Mg-Te, Mg-Th, Mg-Ti, Mg-Tl, Mg-U, Mg-W, Mg-Y, Mg-Zn, Mg-Zr. Examples of ternary or more magnesium alloy include Mg-Al-Mn, Mg-Al-Mn-Zn, Mg-Al-Mn-RE, Mg-Al-Mn-Si, Mg-Mn-Zn, Mg-Mn-Zn-Cu, Mg-Th-Zr, Mg-Th-Zn-Zr, Mg-Zn-RE, Mg-Zn-Zr-RE, Mg-Zr-Y-RE. Magnesium alloy may be quinary or more magnesium alloy.

Magnesium is harmless to the human body and rather it is indispensable to the metabolism of the human body. The inventors have found that magnesium becomes less corrosive as it becomes purer. Therefore, it is beneficial to use multilayer sheets comprising a magnesium film for bags for containing food and as packaging materials for medicine and medical equipment such as injectors.

Next, the method of forming magnesium film will be described below. In this embodiment, magnesium film is formed on resin film that operates as base film by means of an evaporation method. Generally, in an evaporation method, the material to be used for forming film is heated in a container, the inside of which is evacuated to a high degree of vacuum, so as to deposit on the surface of an oppositely disposed substrate. When magnesium is used as film forming material and the container containing magnesium is evacuated to a degree of vacuum of about $10^{-3}$ mmHg by means of a vacuum pump such as rotary pump, the magnesium is instantaneously gasified at a heating temperature of about $300°C$ that is by far lower than the melting point of magnesium, which is $650°C$, so that consequently the formed magnesium film is strengthened and provides strong adhesive force relative to the base film. Additionally, it has been found that, when magnesium containing impurities or a magnesium alloy is used for the evaporation method, magnesium is gasified dominantly to produce highly pure magnesium film. Thus, it has been found that an evaporation method is highly effective to exploit the inherent properties of magnesium.

The use of a magnesium alloy as film forming material in an evaporation method provides an advantage of a low melting point because magnesium alloys generally have a low melting point. Therefore, magnesium can be gasified at a temperature lower than the above described heating temperature ($300°C$) by appropriately setting the degree of vacuum of the container. Thus, as needed, it is advisable to select a desired magnesium alloy, taking into consideration the melting point of the resin film, onto which magnesium is to be deposited by evaporation.

When an evaporation method is used with magnesium or a magnesium alloy for deposition, it is possible to select the degree of vacuum of the container from a broad range between several mmHg through $10^{-8}$ mmHg. Accordingly, degree of freedom of the film forming conditions can be increased.

Next, a film forming of a magnesium film or a magnesium alloy film by a sputtering method (ion plating method) will be discussed below. With a sputtering method, plasma is generated between a pair of electrodes and the target (a magnesium material) placed on the cathode is driven to fly out by means of ions in the plasma and deposited on the substrate, which is made of resin film and placed on the anode which is oppositely disposed the cathode. Argon is generally used as electric discharge gas. When this process is used, magnesium is not dominantly deposited on the resin film unlike the above described evaporation method. In other words, the material of the target is deposited on the resin film without modifying its composition. Thus, it is advisable to use a sputtering method when the composition of a magnesium alloy is to be used for the metal film without modification. A sputtering method additionally provides an advantage that the peel strength of metal film formed on the substrate made of the resin film is more resistant than that of an evaporation method described above.

A film forming of a magnesium film or a magnesium alloy film by an electron beam method is a method where electrons generated from a tungsten filament are accelerated by applying a voltage of several kV and irradiated onto the evaporation material, which is magnesium or a magnesium alloy, so as to gasify the magnesium or the magnesium alloy. According to the electron beam method, even if it is a magnesium alloy which can hardly form a film, it can form a magnesium alloy film. It provides an additional advantage that it produces a high evaporation rate and the formed film shows a high strength level.

Next, the present embodiment will be described by way of an example where magnesium alloys were used and deposited on resin film by evaporation. The base films used in the example had a thickness of 12 µm and were made of polyester. The compositions of magnesium and the magnesium alloys used in the example are listed below.

pure magnesium   (98%)
pure magnesium   (99.6%)

CM10 alloy Mg + Cu (1.5%) + Mn (0.5%) + Al, Si

CM31 alloy Mg + Cu (3%) + Mn (1%) + Al, Si

AZ91R alloy Mg + Al (9%) + Zn (0.6%) + Mn, Si

AM60R alloy Mg + Al (6%) + Mn (0.3%) + Zn, Si

The above alloys were used as coating materials and a magnesium deposit film was formed to a thickness of about 400 Å on a base film for each of the alloys. It was found that the surface metal of the obtained film were substantially formed by magnesium. Aluminum oxide and silicon oxide were also deposited substantially under the same conditions. Since an aluminum film was formed by deposition under the conditions shown below, the temperature was slightly high and the degree of vacuum was slightly low if compared with the desirable film forming conditions for magnesium.

temperature:500 through 600°C
degree of vacuum: 2,5 $\times$ 10$^{-4}$ mmHg
rate:    100 m/min

The barrier effect of each of the obtained multilayer sheets was evaluated. For each specimen, the steam permeability (g/m$^2$·day) was observed by means of a MOCON method under the conditions of an atmospheric temperature of 40°C and a relative humidity of 90% and the oxygen permeability (cc/m$^2$·day) was observed also by means of a MOCON method under the conditions of an atmospheric temperature of 20°C and a relative humidity of 0%. The obtained results are summarized in the table below.

| film material | steam permeability | oxygen permeability |
|---|---|---|
| pure magnesium (98%) | 1.0 | 0.1 |
| pure magnesium (99.6%) | 1.0 | 0.1 |
| CM10 alloy | 1.3 | 0.1 |
| CM31 | 3.4 | 0.1 |
| AZ91R | 1.3 | 0.1 |
| AM60R | 1.4 | 0.1 |
| $Al_2O_3$ | 1.5 | 1.5 |
| $SiO_x$ | 1.0 | 1.0 |

It is obvious from the above table that a multilayer sheet of this embodiment shows an excellent steam permeability and an excellent oxygen permeability in comparison with a multilayer sheet of aluminum oxide and that of silicon oxide.

It will be appreciated that a multilayer sheet according to the invention and a package body formed by using a multilayer sheet according to the invention are not limited to the above described embodiment, which may be modified and altered in various different ways without departing from the scope of the present invention as defined by the claims. For instance, another resin film or a paper film may be laminated further on the multilayer film described above to produce a multilayer structure of three or more than three layers. The material of the base layer is not limited to resin film and paper or the like may alternatively be used for the base layer.

A evaporation process of sublimating solid magnesium or a solid magnesium alloy may alternatively be used for the film forming process.

Pure magnesium has a high shock absorbing property. Therefore, a package sheet having appropriate thickness according to the present invention is very effective when it is used for packaging a delicate object that is highly sensitive to external impacts.

**Industrial Applicability**

As described above in detail, a multilayer sheet comprising a magnesium film according to the present invention is very useful for bags for containing food and as packaging materials for medicine and medical equipment such as injectors. The package sheet according to the present invention is very effective when it is used for packaging a delicate object that is highly sensitive to external impacts.

**Claims**

1. A multilayer sheet comprising a base layer, and at least a metal film layer integrally formed on the base layer, wherein the metal film layer is made from magnesium or a magnesium alloy.

2. The multilayer sheet according to claim 1, wherein the metal film layer is formed on the base layer by means of a sublimation method, an evaporation method, an electron beam method or a sputtering method.

3. A package body made from a multilayer sheet for packaging food, medicine or tool comprising a base layer, and at least a metal film layer integrally formed on the base layer, wherein the metal film layer is made from magnesium or a magnesium alloy.

4. The package body according to claim 3, wherein the metal film layer is formed on the base layer by means of a sublimation method, an evaporation method, an electron beam method or a sputtering method.

## INTERNATIONAL SEARCH REPORT

| International application No. |
|---|
| PCT/JP02/11878 |

**A. CLASSIFICATION OF SUBJECT MATTER**
Int.Cl$^7$ B32B15/04, A61J1/00, B65D30/02, B65D65/40

According to International Patent Classification (IPC) or to both national classification and IPC

**B. FIELDS SEARCHED**

Minimum documentation searched (classification system followed by classification symbols)
Int.Cl$^7$ B32B15/04-15/08, A61J1/00, B65D30/02, B65D65/40

Documentation searched other than minimum documentation to the extent that such documents are included in the fields searched

| | | | |
|---|---|---|---|
| Jitsuyo Shinan Koho | 1926–1996 | Toroku Jitsuyo Shinan Koho | 1994–2002 |
| Kokai Jitsuyo Shinan Koho | 1971–2002 | Jitsuyo Shinan Toroku Koho | 1996–2002 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 10-6432 A (Toppan Printing Co., Ltd.), 13 January, 1998 (13.01.98), Claim 2; Par. Nos. [0002], [0040], [0042] (Family: none) | 1-4 |
| E,X | JP 2002-337265 A (Katsuhiro NISHIYAMA), 27 November, 2002 (27.11.02), Claims (Family: none) | 1-4 |

☐ Further documents are listed in the continuation of Box C.  ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 20 February, 2003 (20.02.03) | 11 March, 2003 (11.03.03) |

| Name and mailing address of the ISA/ | Authorized officer |
|---|---|
| Japanese Patent Office | |
| Facsimile No. | Telephone No. |

Form PCT/ISA/210 (second sheet) (July 1998)